# EUROPEAN PATENT SPECIFICATION

(11) **EP 0 478 562 B1**
(45) Date of publication and mention of the grant of the patent: **04.10.1995**
(21) Application number: 90906685.4
(22) Date of filing: 09.04.1990
(51) Int. Cl.: H01R 9/07, H01R 13/432, H01M 2/10, H01M 2/20

(54) **SNAP FIT CONTACT ASSEMBLY**
ANORDNUNG MIT KONTAKTSCHNAPPBEFESTIGUNG
ENSEMBLE CONTACT ENCLIQUETABLE

(30) Priority: 30.05.1989 US 357913
(43) Date of publication of application: 08.04.1992
(73) Proprietor: MOTOROLA, INC., Schaumburg, IL 60196 (US)
(72) Inventor: MENNONA, Vincent, J., Jr., Boca Raton, Florida 33487 (US)
(74) Representative: Lupton, Frederick
(86) International application number: US9001833
(87) International publication number: WO9015455

(56) References cited:
- EP-A- 0 274 609
- US-A- 4 353 609
- US-A- 4 526 436
- US-A- 4 682 829
- US-A- 4 693 528

## Description

### Background of the Invention

This invention relates to electrical contacts in general and particularly to an electrical contact which can be snap fit into a housing. It is often desirable to have electrical contacts which are mounted into a housing wall. For example, a portable two-way radio typically includes a battery portion which has both charger contacts and connects for connection to the radio. Various approaches are used for mounting the contacts, such as ultrasonic welding of contact carriers or use of molded-in contacts. It is also necessary to connect the contacts to the circuitry on the inside of the housing. One known approach uses the rivets which are affixed to a flex circuit. Rivets, however, do not produce highly reliable electrical connections to flex circuits and require the ultrasonic welding or heat staking of the contact carrier to the housing wall.

US Patent No. 4,353,609 discloses a plug-in type of contact for mounting on a printed circuit board which utilises a special construction that prevents it from falling out of the board during or prior to the soldering process.

It is desirable to have a contact that can be surface mounted to a flex circuit and snap fit into a housing opening.

### Summary of the Invention

In accordance with a first aspect of the present invention there is provided a snap fit electrical contact for insertion into a housing opening having a shoulder therein, the snap fit electrical contact comprising:
a substantially planar top contact surface;
a wall depending from the periphery of the top contact surface, the wall including a snap feature protruding from the wall for engaging the housing shoulder within the housing opening such that the electrical contact is snap fit mounted in the housing opening; and
electrical circuit connection means carried by said wall.

In accordance with a second aspect of the present invention there is provided a housing and snap fit electrical contact assembly comprising:
a housing having an opening with a shoulder therein;
an electrical contact extending into the opening and including, a substantially planar top contact surface, a wall peripherally depending from the top contact surface, the wall including a snap feature and electrical circuit connection means carried by said wall, the snap feature being arranged to engage the housing shoulder within the housing opening such that the electrical contact is snap fit mounted in the housing opening.

In one aspect of the invention, the electrical circuit connection means is a peripheral lip. In another aspect of the invention, the contact surface wall and peripheral lip constitute an integrally formed metal member. In still another aspect of the invention, the snap feature is a tab formed in the wall. In yet another aspect of the invention, the snap feature is protrusions formed in the wall.

### Brief Description of the Drawings

FIG. 1 is a top plan view of a snap fit electrical contact in accordance with the present invention.

FIG. 2 is a cross-sectional view of the electrical contact of FIG. 1 taken on lines 2-2 shown assembled to a housing.

FIG. 3 is a fragmentary elevational view of the electrical contact of FIG. 1.

FIG. 4 is an isometric view of another electrical contact in accordance with the present invention.

FIG. 5 is a side elevational view of the electrical contact of FIG. 4 shown assembled to a housing.

### Description of the Preferred Embodiment

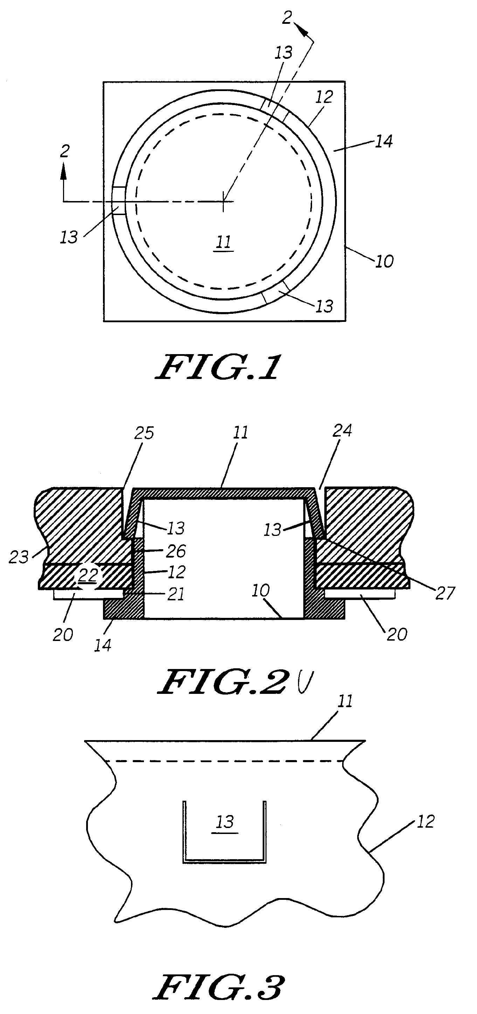

Referring now by characters of reference to the drawings, and first to FIG. 1, it will be understood that the contact 10 includes an upper contact surface 11 which in this case is formed in a circular shape. A side wall 12 depends from the contact surface 11. As is more clearly seen in FIG. 3, tabs 13, constituting snap features are formed in the side wall 12, as by a "U" shaped cut. A peripheral lip, or base 14 extends about the base or flange of the wall 12 and constitutes electrical circuit connection means carried by the wall.

As is illustrated in FIG. 2, the contact 10 is assembled to a flex circuit 20 that has an opening 21. The contact 10 extends through the opening 21 with the flange 14 engaging and being soldered to the flex circuit 20. If desired, a gasket 22 can be positioned about the contact 10 between the flex circuit 20 and a wall of a housing 23. The housing 23 includes an opening 24 that has a larger outside portion 25 and a narrower inside neck portion 26. A shoulder 27 defines the transition between the opening portions 25 and 26.

After soldering the flange 14 of the contact 10 to the flex circuit 20, and positioning of the gasket 22 about the contact, the contact can be pushed through the opening 24 from the inside of a housing 23. The tabs 13 flex or bend to permit the contact 10 to pass through the narrow opening 26 and are received in the wider opening 25. The shoulder 27 between the opening 25 and 26 provide a stop for preventing withdrawal of the contact 10 from the housing opening 24.

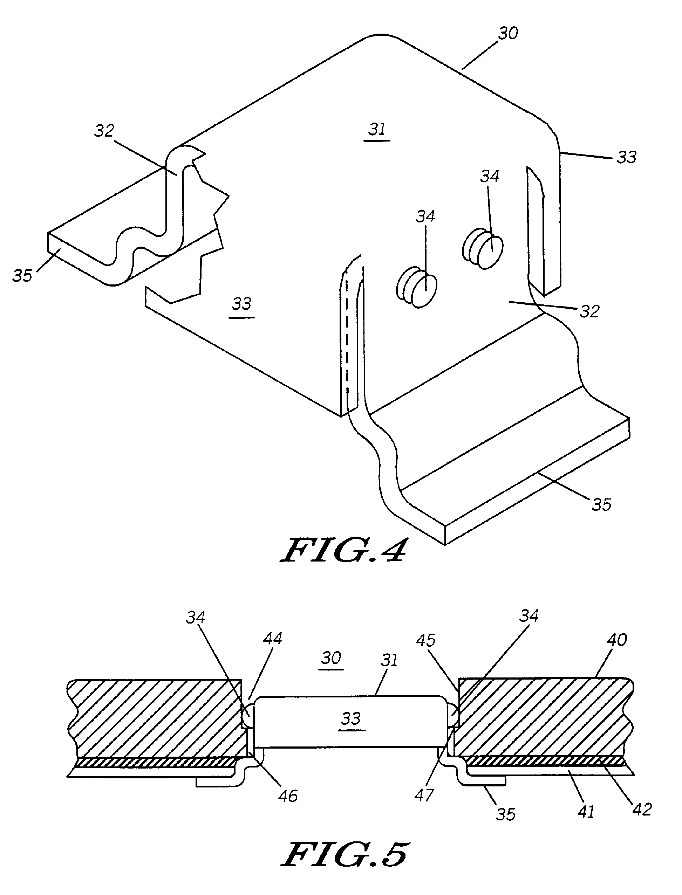

A modified contact 30 is illustrated in FIG. 4. In this case a rectangular or square contact surface 31, is provided with a first pair of opposed side depending walls 32 and a second pair of opposed side depending walls 33. In this case, protrusions 34, constituting snap features, are formed in the walls 32. Lips or flanges 35 are provided at the base of the walls 32 for providing electrical connection of contact 30 as to a flex circuit. As shown in the drawings of Figures 1-5, the contact surfaces 11 and 31 are substantially planar.

FIG. 5 illustrates the contact 30 after assembly to a housing 40. A flex circuit 41 receives contact 30 with flanges soldered to the circuit. A gasket 42 is also provided for rain sealing purposes. A housing opening 44 includes a narrower inside portion 46 and wider outside portion 45 with shoulders 47 defining the transition. The walls 32 can flex to permit the protrusions 34 to pass the narrower portion 46 and seat the shoulders 47.

The contacts 10 and 30 can be stamped and formed from thin metal. Preferably they are plated. Attaching the contacts to a flex circuit first, then snapping the contacts into housing openings provides a low cost, easily manufacturable contact assembly.

## Claims

1. A snap fit electrical contact (10) for insertion into a housing opening (24) having a shoulder therein (27), the snap fit electrical contact comprising:
a substantially planar top contact surface (11);
a wall (12) depending from the periphery of the top contact surface, the wall including a snap feature (13) protruding from the wall (12) for engaging the housing shoulder (27) within the housing opening (24) such that the electrical contact (10) is snap fit mounted in the housing opening (24); and
electrical circuit connection means (14) carried by said wall.

2. A housing and snap fit contact assembly comprising:
a housing having an opening (24) with a shoulder (27) therein;
an electrical contact (10) extending into the opening (24) and including, a substantially planar top contact surface (11), a wall (12) peripherally depending from the top contact surface, the wall including a snap feature (13) and electrical circuit connection means (14) carried by said wall, the snap feature (13) being arranged to engage the housing shoulder within the housing opening (24) such that the electrical contact (10) is snap fit mounted in the housing opening (24).

3. A housing and snap fit electrical contact assembly as defined in claim 2, further including:
a flex circuit (20), the electrical circuit connection means (14) being electrically affixed to the flex circuit (20).

4. A snap fit electrical contact as defined in claim 1 or a housing and snap fit electrical contact assembly as defined in claim 2 or 3, in which said electrical circuit connection means (14) comprises a peripheral lip (14).

5. A snap fit electrical contact as defined in claim 4 or a housing and snap fit electrical contact assembly as defined in claim 4, in which the contact surface (11), wall (12) and peripheral lip (14) constitute an integrally formed metal member.

6. A snap fit electrical contact as defined in claim 1, 4 or 5 or a housing and snap fit electrical contact assembly as defined in claim 2, 3, 4 or 5 in which said snap feature (13) comprises tab means (13) formed in said wall (12).

7. A snap fit electrical contact as defined in claim 1, 4 or 5 or a housing and snap fit electrical contact assembly as defined in claim 2, 3, 4 or 5 in which said snap feature comprises protrusions (34) formed in said wall.

## Patentansprüche

1. Elektrischer Schnappbefestigungs-Kontakt (10) zum Einsetzen in eine Gehäuse-Öffnung mit einer darin befindlichen Schulter (27), welcher elektrischer Schnappbefestigungs-Kontakt umfaßt:
eine im wesentlichen ebene obere Kontaktfläche (11): eine vom Umfang der oberen Kontaktfläche abstehende Wand (12), welche Wand eine von der Wand (12) vorstehende Schnapp-Besonderheit enthält zur Anlage an der Gehäuse-Schulter (27) innerhalb der Gehäuse-Öffnung (24) in der Weise, daß der elektrische Kontakt (10) in der Gehäuse-Öffnung (24) durch Einschnappen befestigt ist; und durch die Wand gehaltenes elektrisches Schaltungs-Verbindungsmittel (14).

2. Anordnung aus Gehäuse und Schnappbefestigungs-Kontakt, welche umfaßt:
ein Gehäuse mit einer Öffnung (24) mit einer darin befindlichen Schulter (27);
einen elektrischen Kontakt (10), der sich in die Öffnung (24) erstreckt und enthält eine im wesentlichen ebene obere Kontaktfläche (11), eine vom Umfang der oberen Kontaktfläche abstehende Wand (12), welche Wand eine Einschnapp-Besonderheit (13) und durch die Wand gehaltenes elektrisches Schaltungs-Verbindungsmittel (14) enthält, welche Einschnapp-Besonderheit (13) zur Anlage an der Gehäuse-Schulter innerhalb der Gehäuse-Öffnung (24) ausgelegt ist in der Weise, das der elektrische Kontakt (10) durch Schnappbefestigung in der Gehäuse-Öffnung angebracht ist.

3. Anordnung aus Gehäuse und elektrischem Schnappbefestigungs-Kontakt nach Anspruch 2, welche weiter enthält:
eine flexible Schaltung (20), wobei das elektrische Schaltungs-Verbindungsmittel (14) elektrisch an der flexiblen Schaltung (20) angebracht ist.

4. Elektrischer Schnappbefestigungs-Kontakt nach Anspruch 1 oder Anordnung aus Gehäuse und elektrischem Schnappbefestigungs-Kontakt nach Anspruch 2 oder 3, bei dem/der das elektrische Schaltungs-Verbindungsmittel (14) eine Umfangs-Lippe (14) umfaßt.

5. Elektrischer Schnappbefestigungs-Kontakt nach Anspruch 4 oder Anordnung aus Gehäuse und elektrischem Schnappbefestigungs-Kontakt nach Anspruch 4, bei dem/der die Kontakt-Fläche (11), die Wand (12) und die Umfangs-Lippe (14) ein intagral ausgebildetes Metallteil bilden.

6. Elektrischer Schnappbefestigungs-Kontakt nach Anspruch 1, 4 oder 5 oder Anordnung aus Gehäuse und elektrischem Schnappbefestigungs-Kontakt nach Anspruch 2, 3, 4 oder 5, bei dem/der die Einschnapp-Besonderheit (13) ein in der Wand (12) ausgebildetes Fahnenmittel (13) umfaßt.

7. Elektrischer Schnappbefestigungs-Kontakt nach Anspruch 1, 4 oder 5 oder Anordnung aus Gehäuse und elektrischem Schnappbefestigungs-Kontakt nach Anspruch 2, 3, 4 oder 5, bei dem/der die Einschnapp-Besonderheit an der Wand ausgebildete vorstehende Teile (34) umfaßt.

## Revendications

1. Élément de contact électrique à encliquetage (10) pour une insertion dans une ouverture de logement (24) possédant un épaulement intégré (27), le contact électrique par encliquetage comprenant :
- une surface de contact supérieure pratiquement plane (11);
- une paroi (12) dépendant de la périphérie de la surface supérieure de contact, la paroi comprenant un élément d'encliquetage (13) dépassant de la paroi (12) pour coopérer avec l'épaulement de logement (27) dans l'ouverture de logement (24) de telle façon que l'élément de contact électrique (10) soit monté par encliquetage dans l'ouverture du logement (24); et
- un moyen de connexion à un circuit électrique (14) porté par ladite paroi.

2. Ensemble de logement et de contact électrique par encliquetage comprenant :
- un logement muni d'une ouverture (24) avec un épaulement intégré (27); et
- un élément de contact électrique (10) s'étendant dans l'ouverture (24) et comprenant une surface supérieure de contact pratiquement plane (11), une paroi (12) dépendant sur la périphérie de la surface supérieure de contact, la paroi comprenant un élément d'encliquetage (13) et un moyen de connexion à un circuit électrique (14) portés par ladite paroi, l'élément d'encliquetage (13) étant agencé pour coopérer avec l'épaulement de logement dans l'ouverture de logement (24) de telle façon que l'élément de contact électrique (10) soit monté par encliquetage dans l'ouverture de logement (24).

3. Ensemble de logement et de contact électrique par encliquetage selon la revendication 2, comprenant, de plus, un circuit flexible (20), le moyen de connexion au circuit électrique (14) étant relié électriquement au circuit flexible (20).

4. Élément de contact électrique par encliquetage selon la revendication 1, ou ensemble de logement et de contact électrique par encliquetage selon la revendication 2 ou 3, dans lequel ledit moyen de connexion au circuit électrique (14) comprend une lèvre périphérique (14).

5. Élément de contact électrique par encliquetage selon la revendication 4, ou ensemble de logement et de contact électrique par encliquetage selon la revendication 4, dans lequel la surface de contact (11), la paroi (12) et la lèvre périphérique (14) constituent une pièce en métal formée de façon intégrale.

6. Élément de contact électrique par encliquetage selon la revendication 1, 4 ou 5 ou ensemble de logement et de contact électrique par encliquetage selon la revendication 2, 3, 4 ou 5, dans lequel ledit élément d'encliquetage (13) comprend un moyen de languette (13) formé dans ladite paroi (12).

7. Élément de contact électrique par encliquetage selon la revendication 1, 4 ou 5 ou ensemble de logement et de contact électrique par encliquetage selon la revendication 2, 3, 4 ou 5, dans lequel ledit élément d'encliquetage comprend des protubérances (34) formées dans ladite paroi.
